# FASCICULE DE BREVET EUROPEEN

(11) **EP 2 231 895 B1**
(45) Date de publication et mention de la délivrance du brevet: **18.10.2017**
(21) Numéro de dépôt: 08867165.6
(22) Date de dépôt: 22.12.2008
(51) Int. Cl.: C23C 14/16, C23C 14/24, C23C 14/54, C23C 14/56, C23C 14/32

(54) **PROCEDE ET DISPOSITIFS DE CONTROLE D'UN FLUX DE VAPEUR EN EVAPORATION SOUS VIDE**
VERFAHREN UND VORRICHTUNGEN ZUR STEUERUNG EINES DAMPFSTROMS IN DER VAKUUMVERDAMPFUNG
METHOD AND DEVICES FOR CONTROLLING A VAPOUR FLOW IN VACUUM EVAPORATION

(30) Priorité: 21.12.2007 BE 200700618; 23.01.2008 EP 08150579
(43) Date de publication de la demande: 29.09.2010
(73) Titulaire: Advanced Galvanisation AG, 8212 Neuhausen am Rheinfall (CH)
(72) Inventeur: VANDEN BRANDE, Pierre, CH-8224 Löhningen (CH)
(74) Mandataire: Callewaert, Koen
(86) Numéro de dépôt international: PCT/EP2008/068202
(87) Numéro de publication internationale: WO 2009/083546

(56) Documents cités:
- EP-A- 1 182 272
- JP-A- 10 152 777
- JP-A- 58 133 374
- US-A- 5 584 973

## Description

### 1. Description générale de l'invention

L'invention est relative à un procédé et un dispositif pour le revêtement de substrats au défilé se déplaçant suivant une direction de défilement, ce dispositif comprenant une enceinte de confinement dans laquelle une source de vapeur du matériau de revêtement est présente et présentant une zone de traitement communiquant avec la source de vapeur à travers au moins une ouverture de traitement. La source de vapeur permet de générer un flux de vapeur pour le revêtement d'un substrat. L'invention concerne donc un dispositif et un procédé de contrôle d'un flux de vapeur vers un substrat à revêtir dans un procédé de revêtement par évaporation sous vide. L'invention est particulièrement avantageuse pour le contrôle et la régulation d'un flux de vapeur de zinc, obtenu par évaporation du métal, vers des substrats en acier se présentant sous la forme de bandes, de poutrelles, de plaques, de profilés, de tous types de sections transversales, mais aussi de pièces disposées sur des supports, par exemple des crochets ou des paniers métalliques, transportés dans la zone de revêtement.

Bien que le contrôle du flux de vapeur évaporée faisant l'objet de l'invention soit totalement indépendant, tant de la nature de la substance évaporée que du type de source d'évaporation utilisée, il est particulièrement bien adapté au contrôle et à la régulation d'un flux de vapeur de zinc vers un substrat à revêtir dans un procédé de galvanisation par évaporation par plasma de zinc. Le matériau de revêtement contenu dans la source de vapeur peut, par exemple, être chauffé par effet Joule, par induction ou par plasma afin de faire évaporer ce matériau.

Le procédé de galvanisation par évaporation par plasma de zinc est déjà connu et décrit dans le document WO 02/16664. Ce procédé met en oeuvre un bac de rétention permettant de maintenir une certaine quantité de zinc à l'état liquide et de l'évaporer au moyen d'un plasma réalisé dans la vapeur de zinc en polarisant en moyenne négativement le zinc liquide par rapport à une contre-électrode, en particulier une anode. La contre-électrode peut être formée par le substrat à revêtir. Le bac de rétention est alimenté en zinc liquide via un tube d'alimentation plongeant dans une réserve de zinc maintenue dans un four à vide situé dans une chambre à vide, isolée à tout passage de gaz vers la cuve à vide de galvanisation, et dans laquelle par régulation de la pression de gaz il est possible de régler le niveau de zinc liquide dans le bac de rétention situé dans la cuve à vide où s'opère la galvanisation. Le plasma réalisé dans la vapeur de zinc est généralement obtenu au moyen d'une décharge magnétron moyennant un circuit magnétique disposé sous le bac de rétention. La tension de vapeur de zinc au dessus du bac de rétention est fonction de la puissance électrique dissipée à la surface du zinc liquide et fixe le poids de zinc qu'il est possible de déposer par unité de temps sur le substrat d'acier. Cette tension de vapeur peut atteindre plusieurs mbar correspondant généralement à une masse de zinc évaporée de plusieurs kg/min. Il est donc recommandé, tel que déjà décrit dans le document WO 02/16664, de prévoir une enceinte de confinement aux parois chauffées pour éviter que la vapeur de zinc n'aille contaminer l'ensemble de l'installation en se condensant sur toutes les surfaces froides, qui sont généralement à température ambiante, autres que celles du substrat. Des ouvertures d'entrée et de sortie sont prévues dans cette enceinte de confinement afin de permettre au substrat à revêtir de la traverser. Le revêtement de zinc s'obtient donc par condensation de la vapeur de zinc, directement à l'état solide sur la surface froide du substrat qui traverse l'enceinte de confinement. La température de la surface du substrat est typiquement inférieure à 150°C.

On comprend aisément qu'il faille pouvoir adapter la puissance électrique délivrée au plasma et dissipée, via bombardement d'ions issus du plasma, à la surface du zinc liquide dans le bac de rétention en fonction de l'aire du substrat d'acier défilant par unité de temps dans l'enceinte de confinement. En particulier, couper cette alimentation électrique lorsqu'aucun substrat n'est présent, ou ne défile, dans l'enceinte de confinement et, inversement, enclencher et progressivement augmenter la puissance électrique dissipée à la surface du zinc liquide lorsque le substrat pénètre, ou se remet à défiler dans, l'enceinte de confinement. Ceci est fait de manière à, non seulement assurer une épaisseur de zinc uniforme à la surface du substrat, mais surtout à limiter les pertes de zinc par les ouvertures d'entrée et de sortie de l'enceinte de confinement lorsqu'aucun substrat ne traverse l'enceinte de confinement. En effet, outre la perte économique, en zinc et en énergie, la contamination en zinc peut gravement endommager l'installation de galvanisation par évaporation plasma si elle n'est pas contrôlée.

L'utilisation d'une enceinte de confinement telle que décrite dans l'art antérieur présente plusieurs désavantages.

En effet, lorsqu'aucun substrat n'est présent ou ne défile dans l'enceinte de confinement, même si l'on coupe l'alimentation électrique permettant l'évaporation du zinc par chauffage par plasma, par exemple, le zinc liquide contenu dans le bac de rétention continue à s'évaporer par suite de la chaleur emmagasinée dans le métal lors du fonctionnement en régime du procédé. Cette vapeur de zinc est donc susceptible de s'échapper librement par les ouvertures d'entrée et de sortie de l'enceinte de confinement ou de se condenser sur un substrat immobile. Pour limiter cette perte en zinc vers l'extérieur de l'enceinte de confinement, ou la condensation du zinc sur un substrat immobile, un moyen simple pourrait consister à vider le bac de rétention de toute présence de zinc liquide en le ramenant dans la réserve de zinc liquide située dans le four de maintien à température dans la cuve située sous la cuve de galvanisation. Malheureusement, le temps des transitoires nécessaires à l'entrée ou la sortie d'un substrat de l'enceinte de confinement, ou à la mise à l'arrêt ou au redémarrage du défilement du substrat, est généralement beaucoup plus faible que le temps nécessaire au remplissage et à la vidange en zinc liquide du bac de rétention par son tube d'alimentation. Par conséquent, cette solution n'est pas envisageable en pratique.

Par ailleurs, lorsqu'un substrat quelconque traverse l'enceinte de confinement, l'enceinte de confinement, telle que décrite dans l'art antérieur, ne permet pas d'adapter le flux de zinc en fonction des différentes faces du substrat à revêtir. Ceci pourrait être important dans le but d'assurer un dépôt uniforme sur l'entièreté du substrat alors que l'aire de la surface du substrat à revêtir varie avec l'orientation du flux de vapeur, comme c'est, par exemple, le cas pour une poutre avec une section en I ou en U. Il n'est également pas possible de revêtir le substrat avec des épaisseurs différentes sur ses différentes faces, par exemple, lorsque l'on souhaite appliquer un revêtement avec une certaine épaisseur sur une des faces d'une tôle d'acier qui est différente de l'épaisseur du revêtement appliquée sur l'autre face de cette tôle. JP 10 152777 décrit un dispositif de revêtement en continu comprenant des moyens de contrôle du flux de vapeur. Le procédé et le dispositif objet de l'invention visent essentiellement à résoudre, entre-autres, ces deux inconvénients en permettant :
- d'isoler l'intérieur de l'enceinte de confinement de la zone de traitement où passe le substrat à revêtir. Cette fonction est activée lorsqu'aucun substrat ne traverse la zone de traitement ou ne défile dans cette zone de traitement.
- de réguler le flux de vapeur en fonction de son orientation vers le substrat transversalement par rapport à la direction de défilement, ou en fonction de la position de la source de vapeur dans l'enceinte de confinement par rapport à la zone de traitement, par réglage d'au moins un élément d'obturation de la vapeur.

A cet effet, des moyens de réglage sont prévus permettant de contrôler le flux de ladite vapeur entre ladite source de vapeur et la zone de traitement à travers ladite ouverture de traitement. Ces moyens de réglage comprennent des éléments d'obturation pouvant être déplacés entre une position d'ouverture, dans laquelle le flux de ladite vapeur peut passer à travers l'ouverture de traitement vers la zone de traitement, et une position de fermeture, dans laquelle la zone de traitement est isolée par rapport à la source de vapeur.

Dans une configuration particulièrement avantageuse de l'invention, un couloir s'étend suivant la direction de défilement des substrats entre une ouverture d'entrée et une ouverture de sortie de l'enceinte de confinement, ladite zone de traitement étant située dans ce couloir et lesdits moyens de réglage étant tels à permettre de contrôler le flux de ladite vapeur entre ladite source de vapeur et l'intérieur du couloir.

Les ouvertures d'entrée et de sortie de l'enceinte de confinement sont ainsi reliées entre-elles par un couloir en forme de tube traversant totalement l'enceinte de confinement et présentant des dispositifs d'ouverture et de fermeture permettant le passage de la vapeur de l'intérieur de l'enceinte de confinement vers la zone de traitement traversée par le substrat. Lorsqu'aucun substrat ne traverse ou ne défile dans la zone de traitement, toutes les ouvertures de ce tube traversant l'enceinte de confinement de part-en-part sont obturées. Lorsqu'un substrat traverse la zone de traitement, les ouvertures du couloir sont plus ou moins ouvertes en fonction du flux de vapeur désiré au droit de chacune d'entre-elles vers le substrat.

Un dispositif de chauffage, par exemple par effet Joule, des parois de l'enceinte de confinement est prévu et dimensionné pour atteindre une température des parois suffisante pour empêcher toute condensation solide ou liquide de la vapeur métallique sur lesdites parois. Ce système de chauffage de l'enceinte de confinement peut aussi avantageusement permettre, par radiation, le maintien à cette même température, empêchant toute condensation de la vapeur de zinc, des parois constitutives du couloir de régulation du flux de vapeur traversant l'enceinte de confinement. Ceci permet de simplifier la conception du dispositif de régulation du flux de vapeur qui peut simplement faire usage d'une simple construction mécanique constituée d'éléments d'obturation, de géométrie généralement quelconque, pouvant être déplacés entre une position d'ouverture, dans laquelle le flux de ladite vapeur peut passer à travers l'ouverture de traitement vers la zone de traitement, et une position de fermeture, dans laquelle la zone de traitement est isolée par rapport à la source de vapeur de géométrie généralement quelconque.

Il est clair que l'invention n'est pas limitée à un dispositif de galvanisation par plasma et à une enceinte de confinement traversée de part-en-part par un couloir en forme de tube avec des éléments d'obturation réglables. En effet, l'évaporation sous vide pourrait être obtenue par tout moyen de chauffage au moyen d'une source généralement quelconque de vapeur. Le matériau n'est pas limité au zinc. D'autres métaux tels du magnésium, par exemple, ou encore des molécules organiques en vue de déposer des polymères sont possibles. Le système d'éléments d'obturation réglables n'est pas nécessairement constitué d'une structure tubulaire traversant l'enceinte de confinement de part-en-part, mais pourrait par exemple présenter une géométrie plane obturant une ouverture de traitement percée dans une paroi de l'enceinte de confinement et faisant face à une zone du substrat à revêtir.

### 2. Description des figures

D'autres détails et particularités de l'invention ressortiront de la description donnée ci-après à titre d'exemple non limitatif d'une forme de réalisation particulière du dispositif et du procédé suivant l'invention avec référence aux dessins annexés.
La figure 1 représente, en perspective, un dispositif de galvanisation par plasma, tel que décrit dans l'art antérieur.
La figure 2 est une représentation schématique en perspective d'une enceinte de confinement, suivant l'invention, dont la zone de traitement, qui est munie d'éléments d'obturation formés par des lamelles articulées, s'étend entre une ouverture d'entrée et une ouverture de sortie de l'enceinte.
La figure 3 est une représentation schématique en perspective des parois de la zone de traitement qui sont formées par une succession de lamelles parallèles articulées, suivant l'invention.
La figure 4 est une représentation schématique en perspective d'une enceinte de confinement avec une zone de traitement dont les parois sont formées par des éléments d'obturation en forme de tiroirs, suivant l'invention.
La figure 5 est une représentation schématique en perspective d'une enceinte de confinement avec une zone de traitement dont les parois forment des éléments d'obturation plans qui peuvent être déplacés parallèlement ou perpendiculairement par rapport à leur plan, suivant l'invention.
La figure 6 est une représentation schématique d'une forme particulièrement avantageuse du dispositif selon l'invention dans une installation de galvanisation par plasma, lorsque des substrats défilent à travers la zone de traitement et les éléments d'obturation sont dans leur position d'ouverture.
La figure 7 représente le dispositif, selon l'invention, de la figure 6 en absence de substrats et lorsque les éléments d'obturation sont dans leur position de fermeture.

Dans les différentes figures, les mêmes chiffres de référence se rapportent à des éléments analogues ou identiques.

### 3. Description détaillée de l'invention

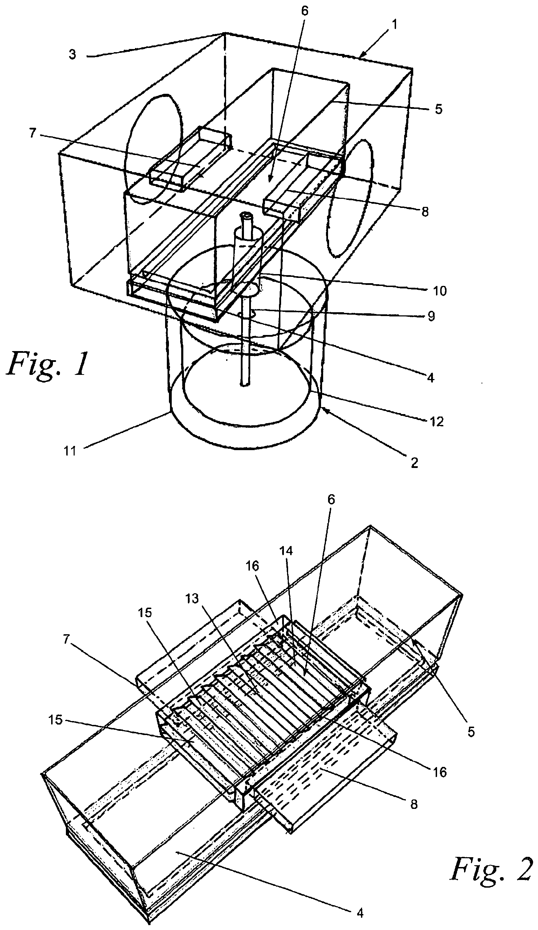

Comme représenté à la figure 1, le dispositif de galvanisation, suivant l'art antérieur, est constitué d'un équipement supérieur 1 traversé par le substrat à revêtir et d'un équipement inférieur 2 comprenant une réserve de zinc liquide.

L'équipement supérieur 1 comprend une chambre à vide 3 dans laquelle est agencée une source de vapeur formée par un bac de rétention 4 surmonté d'une enceinte de confinement 5. L'enceinte de confinement présente des parois chauffées afin d'éviter le dépôt de la vapeur sur ces parois et est de forme tubulaire permettant la libre circulation et la répartition de la vapeur tout autour du produit à revêtir sans fuite de vapeur dans une direction transversale à la direction de déplacement du substrat à revêtir.

Le zinc liquide qui est présent dans le bac de rétention 4 est évaporé par un plasma généré dans l'enceinte de confinement 5 afin de créer un flux de vapeur de zinc vers une zone de traitement 6 qui est traversée par le substrat à revêtir. Cette zone de traitement 6 s'étend entre une ouverture d'entrée 7 et une ouverture de sortie 8 de l'enceinte de confinement 5 et correspond à un couloir qui relie les ouvertures 7 et 8 de l'enceinte de confinement 5. La zone de traitement 6 est située au dessus du bac de rétention 4 et communique avec l'intérieur de l'enceinte de confinement 5 à travers les parois ouvertes de ce couloir qui forment ainsi des ouvertures de traitement.

L'alimentation du bac de rétention 4 se fait par l'intermédiaire d'un tube d'alimentation 9 traversant une connexion 10 étanche au gaz située entre la cuve à vide 3 de l'équipement supérieur 1 et une deuxième cuve à vide 11 de l'équipement inférieur 2. Ce tube d'alimentation 9 débouche dans le fond du bac de rétention 4 et plonge dans une réserve de zinc liquide stockée dans un four de maintien à température 12 dans la deuxième cuve à vide 11.

Comme il apparaît clairement sur cette figure 1, l'enceinte de confinement 5, suivant l'art antérieur, ne comprend aucun dispositif permettant de réguler le flux de vapeur de zinc vers les différentes faces du substrat qui serait présent dans la zone de traitement 6 ou de bloquer le passage de cette vapeur lorsqu'aucun substrat n'est présent dans la zone de traitement 6.

La figure 2 représente l'enceinte de confinement 5 avec la zone de traitement 6 de la figure 1 présentant des moyens de réglage permettant de contrôler le flux de vapeur du matériau de revêtement entre la source de vapeur 4 et la zone de traitement 6 à travers les ouvertures de traitement 14, suivant une forme de réalisation avantageuse de l'invention.

L'espace à l'intérieur de l'enceinte de confinement 5 permet de distribuer la vapeur du matériau de revêtement tout autour du produit à revêtir et/ou autour du couloir. Ainsi, un espace libre est de préférence présent entre les parois de l'enceinte de confinement et les parois du couloir permettant une circulation libre et une distribution de la vapeur dans l'enceinte de confinement.

Le couloir, qui comprend la zone de traitement 6, présente de préférence une structure tubulaire et est délimité par des parois qui s'étendent entre l'ouverture d'entrée 7 et l'ouverture de sortie 8. Ainsi, les parois du couloir entourent la zone de traitement 6. Ces parois présentent les ouvertures de traitement 14 et comprennent les moyens de réglage permettant de fermer ou d'ouvrir ces ouvertures de traitement 14 et de régler le flux de vapeur dans des directions transversales à la direction de déplacement du substrat..

Les moyens de réglage comprennent des éléments d'obturation 13 qui peuvent être déplacés entre une position d'ouverture, dans laquelle le flux de ladite vapeur peut passer à travers l'ouverture de traitement vers la zone de traitement 6, et une position de fermeture, dans laquelle la zone de traitement 6 est isolée par rapport à la source de vapeur 4.

Les parois du couloir, qui s'étend suivant la direction de défilement des substrats entre l'ouverture d'entrée 7 et l'ouverture de sortie 8 de l'enceinte de confinement 5 et qui comprend ladite zone de traitement 6, sont constituées par des éléments d'obturation 13 qui peuvent être déplacés entre une position d'ouverture et une position de fermeture. Dans la position d'ouverture, l'ouverture de traitement est au moins partiellement ouverte et le flux de ladite vapeur peut pénétrer à l'intérieur du couloir à partir de la source de vapeur 4 à travers cette ouverture de traitement. Dans la position de fermeture l'intérieur du couloir, c.à.d. la zone de traitement, est isolé par les éléments d'obturation 13 par rapport à la source de vapeur 4. Ainsi, les parois du couloir peuvent être déplacées entre une position de fermeture et une position d'ouverture.

Les éléments d'obturation 13 sont formés par des lamelles 15 qui sont articulées par rapport à l'ouverture de traitement de manière à permettre de les basculer entre la position d'ouverture et la position de fermeture. Les lamelles 15 présentent une forme oblongue et leur direction longitudinale s'étend parallèlement à la direction de défilement des substrats entre l'ouverture d'entrée 7 et l'ouverture de sortie 8 de l'enceinte de confinement 5.

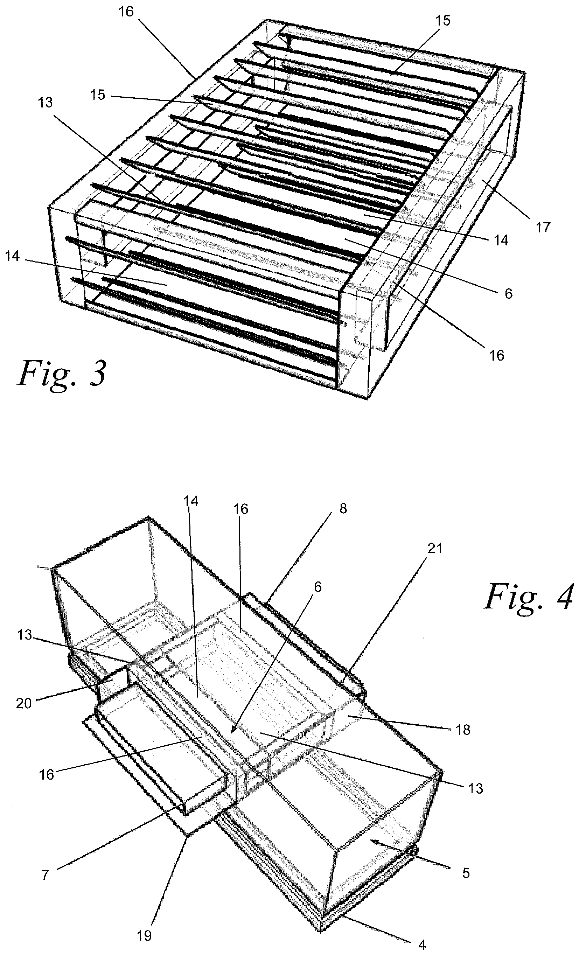

Dans la figure 3 les parois du couloir sont représentées. Ces parois comprennent lesdits éléments d'obturation 13 formés par les lamelles 15 et constituent ainsi une sorte de stores vénitiens qui peuvent obturer l'ouverture de traitement afin d'isoler la zone de traitement par rapport à l'enceinte de confinement 5.

Le couloir présente une structure tubulaire composée de parois présentant des lamelles 15 rectangulaires parallèles entre eux et fixées par un axe mobile médian dans des cadres supports 16. Les cadres supports 16 présentent des ouvertures 17 qui sont adjacentes à, respectivement, l'ouverture d'entrée 7 et l'ouverture de sortie 8 de l'enceinte de confinement 5 et qui permettent le passage du substrat à revêtir. Par rotation autour d'un axe médian des lamelles 15, ces dernières peuvent être ouvertes ou fermées comme des persiennes. Un dispositif pour entrainer la rotation des lamelles n'est pas représenté pour la clarté de la figure. La rotation de chaque lamelle 15 peut se faire de manière généralement indépendante. Ceci donne la plus grande souplesse au procédé de revêtement. Le dispositif d'entrainement des lamelles 15 peut comprendre, par exemple, des moteurs ou des vérins, et est avantageusement situé à l'extérieur de l'enceinte de confinement 5 pour ne pas être contaminé par la vapeur produite par la source de vapeur 4.

La figure 4 représente une enceinte de confinement 5 avec une zone de traitement 6 qui est différente de celle représentée dans la figure 2 par le fait que les parois du couloir contenant la zone de traitement sont formées par des tiroirs 18, 19, 20 et 21.

Dans cette configuration particulière du dispositif selon l'invention, les tiroirs 18, 19, 20 et 21 peuvent être déplacés parallèlement à l'axe central du couloir ou, en d'autres mots, parallèlement à la direction de défilement des substrats à travers la zone de traitement 6. En tirant ces tiroirs 18, 19, 20 et 21 en dehors de l'enceinte de confinement 5, on ouvre, proportionnellement à l'aire tirée du tiroir 18, 19, 20 ou 21 concerné en dehors de l'enceinte de confinement 5, l'ouverture permettant le passage de la vapeur vers la zone de traitement dans une direction perpendiculaire au tiroir tiré. Les tiroirs 18, 19, 20 et 21 sont ramenés à l'intérieur de l'enceinte 5 pour obturer toute l'ouverture de traitement et pour empêcher le passage de la vapeur vers la zone de traitement 6 lorsqu'aucun substrat ne traverse cette zone de traitement 6, et ainsi minimiser les pertes de vapeur vers l'extérieur.

Il est également possible que les parois ou les tiroirs du couloir soient constitués d'une ou plusieurs lamelles s'étendant l'une à côté de l'autre pour permettre une régulation du flux de vapeur plus précise autour du substrat. Dans un tel cas, chaque lamelle peut être déplacée individuellement parallèlement à la direction de défilement des substrats.

Les tiroirs 18, 19, 20 et 21 sont constitués par des plaques qui sont, par exemple, actionnées à l'aide de vérins non représentés et fixées aux parois extérieures de l'enceinte 5.

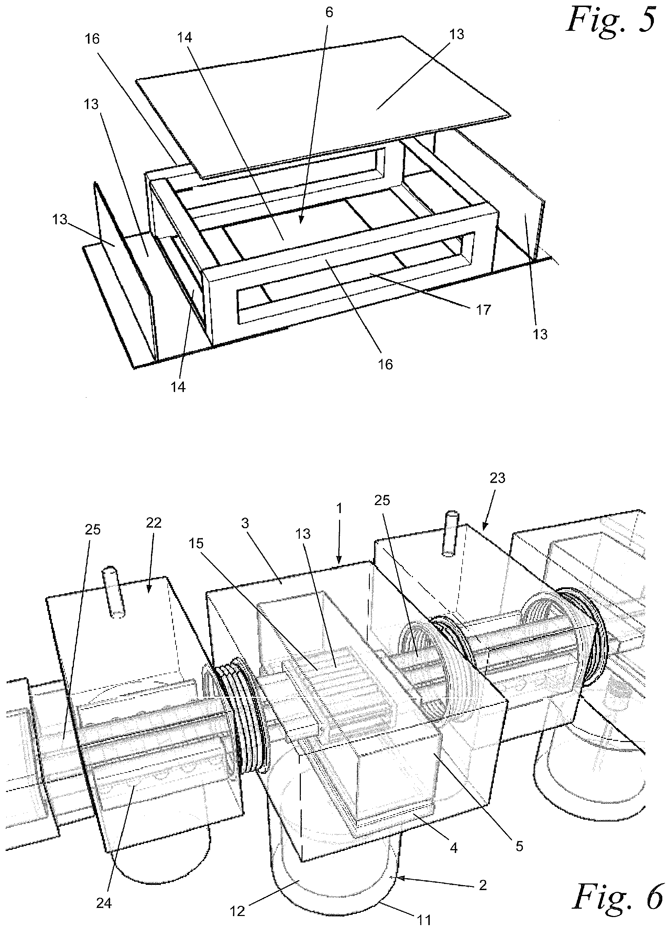

La figure 5 représente une zone de traitement 6 qui est prévue dans un couloir dont les parois forment des éléments d'obturation plans 13 qui peuvent être déplacés parallèlement ou perpendiculairement par rapport à leur plan.

Cette configuration particulière du dispositif selon l'invention illustre le fait que les éléments d'obturation peuvent être déplacés de manière généralement quelconque. Par exemple, perpendiculairement à leur plan à l'intérieur de l'enceinte de confinement 5 comme c'est le cas pour l'élément d'obturation supérieur et pour les deux éléments d'obturation latéraux. La paroi inférieure comprend, par exemple, deux éléments d'obturation 13 qui peuvent être déplacés dans leur propre plan et perpendiculairement à la direction de défilement des substrats non représentés. Les substrats peuvent défiler à travers les ouvertures 17 présentes dans les cadres supports 16 de part et d'autre de la zone de traitement 6.

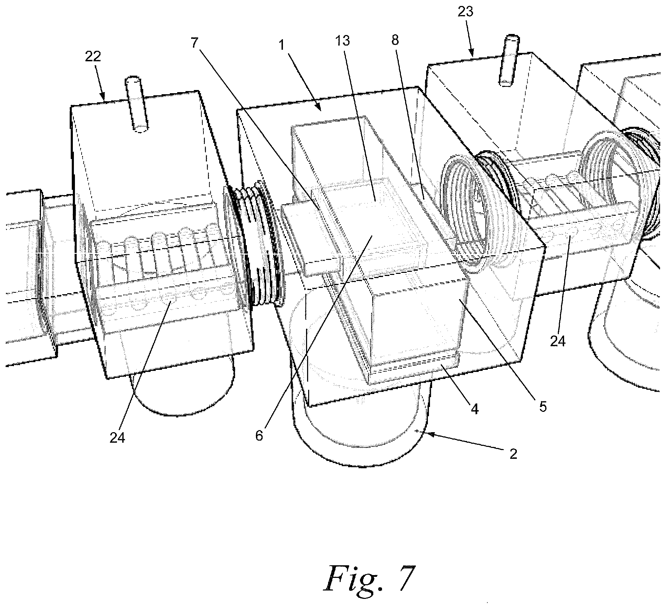

Les figures 6 et 7 montrent le dispositif selon l'invention, dans une installation de galvanisation par plasma. Cette installation comprend, en particulier, un système de transport des substrats par bancs de rouleaux motorisés 24 montés dans une cuve à vide 22 et 23 en aval et en amont du dispositif, suivant l'invention, comprenant le bac de rétention 4 surmonté de l'enceinte de confinement 5 présentant la zone de traitement 6. Bien entendu d'autres systèmes de transport peuvent être envisagés tels qu'un système de transport par monorail permettant de suspendre les substrats et de les transporter à travers les différentes zones de l'installation.

Les substrats sont introduits dans l'installation au moyen d'un sas à vide, non représenté, qui permet de maintenir constamment la zone de traitement 6 et l'enceinte de confinement 5 sous vide ou sous la pression d'argon requise et évite ainsi de contaminer la zone de traitement par introduction d'air. La pression d'argon requise est typiquement comprise entre 0,05 et 5 Pa.

Les substrats quittent l'installation au moyen d'un sas à vide de sortie qui n'est également pas représenté dans les figures.

Le dispositif, suivant l'invention, représenté au figures 6 et 7 fait usage d'un système de régulation du flux de vapeur présentant des éléments d'obturation 13 en forme de lamelles 15. Ce système de régulation du flux de vapeur du matériau de revêtement est représenté aux figures 2 et 3. Lors du passage des substrats 25 à galvaniser à travers la zone de traitement 6 de l'équipement supérieur 1, les lamelles 15 sont ouvertes pour permettre le passage de la vapeur de zinc vers les substrats 25, comme représenté dans la figure 6.

En absence de substrat 25 traversant la zone de traitement 6, les lamelles 15 de régulation du flux de vapeur de zinc vers la zone de traitement 6 sont totalement fermées pour limiter au maximum les pertes en vapeur de zinc dans la chambre à vide 3, comme représenté dans la figure 7. Ainsi, les parois du couloir sont dans leur position de fermeture de sorte que la zone de traitement 6 soit isolée par rapport à l'intérieur de l'enceinte de confinement 5 où la vapeur du matériau de revêtement est présente.

### 4. Conditions opérationnelles et configurations particulières de l'invention dans une installation de galvanisation par plasma

### 4.1. Mise en marche de l'unité de zingage par évaporation par plasma

Lors de la mise sous vide de l'installation de zingage par évaporation par plasma après un entretien, les éléments d'obturation formés par des volets 13 des baffles du dispositif de régulation de la vapeur sont disposés en positions telles que les ouvertures réglables du dispositif soient ouvertes au maximum pour permettre l'évacuation de l'air et puis la mise à la pression voulue d'argon à l'intérieur de l'enceinte de confinement. Lorsque l'installation atteint une pression d'argon comprise entre 0.001 et 0.01 mbar les parois de l'enceinte de confinement sont chauffées par des résistances électriques à une température comprise entre 400 et 500°C. Les volets 13 des baffles du dispositif de régulation du flux de vapeur de zinc selon les figures 2 et 3 sont actionnés par rotation de manière à fermer les ouvertures et isoler ainsi optiquement, la zone de traitement 6, de l'intérieur de l'enceinte de confinement. Les volets 13 des baffles du dispositif de régulation de vapeur sont chauffés par la radiation infrarouge émise par les parois internes de l'enceinte de confinement 5. Avantageusement, quelques volets 13 sont munis de thermocouples pour contrôler leur température. Lorsque la température de travail est atteinte sur les volets 13 (typiquement entre 400 et 500°C) le zinc liquide est introduit jusqu'à son niveau de consigne mesuré par un moyen généralement quelconque électrique, optique ou mécanique dans le bac de rétention 4.

### 4.2. Dispositif particulier d'entrainement des éléments d'obturation constitués de lamelles successives pouvant être balancées entre une position d'ouverture et une position de fermeture pour la régulation du flux de vapeur de zinc transversalement à la direction de déplacement du substrat

Dans une forme particulièrement avantageuse de l'invention, les éléments d'obturation 13 formés par des lamelles 15, comme représenté aux figures 2 et 3, sont supportés sur des axes fixés au support 16. La rotation d'un groupe de lamelles 15 est rendue solidaire par un moyen généralement quelconque, comme, par exemple, par une chaine, par des câbles, ou par un levier coopérant avec une glissière. Ceci est réalisé pour les quatre parois du couloir qui s'étendent parallèlement à la direction de défilement des substrats. De cette façon le dispositif peut être ouvert de manière régulée. En particulier, l'ouverture de traitement pour chacune des parois du couloir contenant la zone de traitement peut être ouverte et fermée de manière indépendante. Ces parois sont, respectivement, situées au dessus, en dessous et latéralement par rapport à la zone de traitement 6 du substrat et s'étendent entre l'ouverture d'entrée 7 et l'ouverture de sortie 8. Avantageusement, l'entrainement mécanique des éléments d'obturation 13 se fait au moyen de quatre dispositifs indépendants fixés sur les parois extérieures de l'enceinte de confinement 5 maintenues à température ambiante (environ 300K) via quatre transmissions traversant les parois de l'enceinte de confinement 5. Les dispositifs mécaniques d'entrainement peuvent être des vérins ou des dispositifs tournants et peuvent être généralement électromécaniques, pneumatiques ou hydrauliques.

L'avantage de cette configuration particulière du dispositif selon l'invention est de pouvoir réguler le flux de vapeur de zinc par direction en fonction de l'aire du substrat à revêtir dépendant de la direction transversale considérée pour un substrat de géométrie déterminé. Il est, en particulier, possible de régler la répartition du passage de la vapeur vers la zone de traitement en fonction de la section transversale des substrats à revêtir.

Ainsi, par exemple, pour un substrat en acier avec une section transversale en forme de U, dont l'ouverture est orientée vers le haut et dont les dimensions principales en section sont équivalentes, en négligeant l'épaisseur du substrat, on doit avoir un flux de vapeur de zinc qui est trois fois plus important à travers la paroi du couloir située au dessus du substrat qu'à travers les parois situées en dessous et sur les côtés du substrat puisque la surface intérieure du U est trois fois plus importante que chacune des surfaces latérales et inférieure. La surface intérieure du U est essentiellement revêtue par le zinc traversant la paroi supérieure. Cette paroi supérieure sera donc totalement ouverte alors que les parois latérales et la paroi inférieure seront partiellement fermées.

En général, le degré de fermeture de chaque paroi dépend non seulement de la géométrie du substrat, mais aussi de la taille du substrat par rapport aux dimensions transversales de la section du couloir constituant la zone de traitement, du nombre et de la répartition des substrats dans la zone de traitement lorsque plusieurs substrats sont traités en parallèle, et de la proximité de la source de vapeur par rapport à chaque paroi.

A titre d'exemple, si trois substrats, avec une section transversale en U comme décrit ci-dessus, sont traités en parallèle et répartis à équidistance dans la zone de traitement, les ouvertures caractéristiques des parois pouvant conduire à un revêtement uniforme sur toutes les faces du substrat pourraient typiquement être : 100% d'ouverture pour la surface supérieure, 60% pour la surface inférieure, et 20% pour les deux surfaces latérales.

Dans le cas du zingage d'une tôle ou de plaques d'acier, dans le but d'obtenir une épaisseur de dépôt uniforme sur les deux faces d'une tôle ou de la plaque se déplaçant horizontalement dans zone de traitement 6 au dessus du bac de rétention 4, il faudra ouvrir totalement les éléments d'obturations 13 situés au dessus de la tôle ou de la plaque et partiellement refermer les éléments d'obturations situés entre le bac de rétention et la tôle ou la plaque de manière à réguler les flux de vapeur de zinc dans l'enceinte de confinement et d'obtenir un flux de vapeur de zinc identique sur les deux faces de la tôle ou de la plaque. En général, les éléments d'obturation situés en regard des bords latéraux de la tôle ou de la plaque ne sont pas nécessaires pour l'application du dispositif, selon l'invention, au zingage d'une tôle ou de plaques d'acier. On peut avantageusement faire usage de parois latérales gauche et droite fixes obturant tout passage de vapeur suivant une direction perpendiculaire à ces parois.

### 4.3. Gestion de l'unité de zingage par évaporation par plasma munie d'un dispositif selon l'invention en régime de fonctionnement

Lorsqu'aucun substrat ne se trouve dans la zone de traitement 6 à l'intérieur du couloir, les éléments d'obturation 13 sont maintenus en positions telles que toutes les parois ou les ouvertures de traitement soient fermées.

Lorsque le substrat est détecté comme se trouvant partiellement ou totalement à l'intérieur de la zone de traitement par l'un, l'autre ou les deux détecteurs situés au voisinage des ouvertures d'entrée et de sortie 7 et 8, les éléments d'obturation 13 sont actionnés pour permettre aux parois de s'ouvrir en assurant ainsi le passage de la vapeur de zinc vers le substrat selon un degré voulu en fonction du flux de vapeur de zinc souhaité et/ou en fonction de l'orientation des éléments d'obturation par rapport au sens de défilement du substrat. Le degré d'ouverture des éléments d'obturation est généralement préréglé en fonction des caractéristiques des substrats à traiter, par exemple, en fonction de la géométrie et le nombre de substrats traités en parallèle.

Lorsque les éléments d'obturation 13 s'ouvrent, l'alimentation électrique connectée au bac de rétention 4 et à une anode, non représentée et située dans l'enceinte de confinement 5 entre le bac de rétention 4 et le couloir comprenant la zone de traitement, et permettant l'obtention du plasma dans la vapeur de zinc nécessaire à l'évaporation du zinc liquide introduit dans ce bac rétention est enclenchée. La puissance délivrée au plasma par cette alimentation électrique est augmentée selon un programme préétabli jusqu'à sa puissance nominale lorsque les deux détecteurs d'entrée et de sortie sont activés par le substrat. Finalement lorsque seul le détecteur situé au voisinage de l'ouverture de sortie 8 de l'enceinte 5 est activé par le substrat, la puissance délivrée par cette alimentation électrique est diminuée jusqu'à sa coupure suivant un programme préétabli. Lorsque le substrat est totalement sorti de la zone de traitement et qu'il n'est plus détecté par les détecteurs situés aux voisinages des ouvertures d'entrée et de sortie 7 et 8 de l'enceinte de confinement 5, les éléments d'obturation 13 sont actionnés afin d'obturer totalement les ouvertures de traitement dans les parois du couloir et ainsi minimiser les pertes en vapeur de zinc à l'extérieur de l'enceinte de confinement 5.

Un avantage important du procédé selon l'invention, apporté par l'obturation de la zone de traitement par rapport à l'enceinte de confinement contenant la vapeur de zinc, lorsqu'aucun substrat ne le traverse ou n'y défile, est qu'empêchant les pertes de zinc par évaporation vers la zone de traitement du substrat, le système est maintenu à l'équilibre thermodynamique, à la température des parois de l'enceinte de confinement, sans devoir maintenir de la puissance électrique dans le plasma, tout en évitant tout risque de solidification du zinc liquide dans le bac de rétention.

### 4.4. Mise à l'arrêt de l'unité de zingage par évaporation plasma munie du dispositif de régulation du flux de vapeur

Lors de la mise à l'arrêt de l'unité de galvanisation par évaporation par plasma, aucun substrat n'étant plus détecté dans la zone de traitement, les éléments d'obturation sont en position fermée. Le bac de rétention 4 est alors vidé vers son four de maintien en température 12 via le tube d'alimentation 9. Lorsque le bac 4 est vidé de tout zinc liquide, les éléments d'obturation sont totalement ouverts pour permettre le passage des gaz entre l'intérieur et l'extérieur de l'enceinte de confinement 5. Les éléments chauffants de l'enceinte de confinement sont alors coupés pour permettre le refroidissement des parois internes de l'enceinte avant la remise à l'air de l'installation pour entretien.

### 5. Exemples d'applications pratiques

### 5.1. Installation pour la galvanisation par évaporation par plasma de profilés en acier

Une installation de galvanisation de profilés en acier par évaporation par plasma est équipée d'enceintes de confinement munies d'un dispositif de régulation du flux de vapeur de zinc à lamelles articulées 15, telle que représentée aux figures 2 et 3. Le régulateur du flux de vapeur est pourvu de quatre parois indépendantes permettant une régulation indépendante du flux de vapeur de zinc respectivement au dessus, en dessous, et sur les côtés de la charge traversant la zone de traitement. Les éléments d'obturation des quatre parois correspondant aux quatre orientations transverses principales au sens de défilement de la charge à galvaniser sont actionnés par rotation des lamelles 15 correspondantes au moyen de vérins (non représentés) fixés sur les parois extérieures de l'enceinte de confinement 5. La section de l'ouverture 17 pour le passage des substrats au niveau des cadres supports 16 mesure typiquement 700 mm x 200 mm et la dimension du couloir ou de la zone de traitement parallèle au sens de défilement du substrat mesure 600 mm. Lorsque les substrats sont détectés comme traversant la zone de traitement, les lamelles 15 sont ouvertes pour chacune des quatre parois indépendantes selon un degré d'ouverture permettant un revêtement uniforme des substrats sur toutes leurs faces. Typiquement, la paroi située au dessus des substrats est ouverte à 100%, la paroi située en dessous des substrats est ouvert à 80%, les parois latérales sont ouvertes à 50%. Lorsque la charge est totalement sortie de la zone de traitement, les éléments d'obturations indépendants sont totalement refermés et l'alimentation électrique connectée entre le bac de rétention et l'anode lui faisant face (non représentée) est coupée de manière à minimiser autant que possible les pertes en zinc vers l'extérieur de l'enceinte de confinement. Ce dispositif de régulation du flux de vapeur de zinc permet la régulation transversale autour de la charge d'un flux nominal de vapeur de zinc de l'ordre de 3,5 kg par minute.

### 5.2. Installation de galvanisation par évaporation par plasma de tôles d'acier au défilé

Une installation de galvanisation au défilé de tôles d'acier par évaporation par plasma est équipée d'enceintes de confinement traversées horizontalement par une tôle d'acier de 1 mm d'épaisseur et de 1 m de largeur, à une vitesse de 100 m/min, un côté de la tôle faisant face au bac de rétention 4. Chaque enceinte de confinement dispose d'un dispositif de régulation du flux de vapeur de zinc muni d'un baffle à tiroir supérieur situé au dessus de la tôle et d'un baffle à tiroir inférieur situé en dessous de la tôle, tel que représenté sur la Figure 4, et actionnés de manière indépendante par des vérins fixés sur les parois extérieures de l'enceinte de confinement (non représenté). Les parois latérales du dispositif de régulation de vapeur de zinc sont fixes étant donnée la géométrie plane de la tôle. Les dimensions intérieures du dispositif de régulation du flux de vapeur sont 1100 x 50 mm pour l'ouverture 17 du cadres support 16 et 600 mm pour la dimension longitudinale suivant la direction de déplacement de la tôle. En fonctionnement, afin d'avoir un dépôt d'épaisseur uniforme sur la totalité de la surface de la tôle, le tiroir supérieur est ouvert à 100% alors que le tiroir inférieur n'est ouvert qu'à 70% de son ouverture totale.

Ce dispositif est particulièrement avantageux pour la galvanisation des tôles d'acier car il permet aussi de s'affranchir totalement de la nécessité d'utiliser des accumulateurs généralement nécessaires dans les procédés de revêtement en continu lors des changements de bobine d'acier, ce qui constitue une économie d'investissement très importante. En effet, lors de l'arrêt du défilement de la bande, en plus de la coupure de l'alimentation électrique permettant l'évaporation du zinc par plasma, la fermeture totale des tiroirs supérieur et inférieur du dispositif de régulation du flux de vapeur protège totalement la tôle de tout dépôt éventuel de zinc durant le temps d'arrêt de la bande et assure ainsi non seulement la réalisation d'une épaisseur de zinc uniforme sur tout le substrat mais aussi la qualité du dépôt car ce dernier n'est réalisé qu'en présence d'un plasma. Il est bien connu que la présence d'ions lors d'un processus de condensation sous vide d'un métal sur un substrat améliore la qualité du revêtement.

Ce dispositif de régulation du flux de vapeur de zinc permet la régulation vers les deux faces de la tôle d'un flux nominal de vapeur de zinc de l'ordre de 3,5 kg par minute.

Il va de soi que l'invention ne se limite pas uniquement aux géométries et mécanismes des dispositifs de régulation du flux de vapeur décrits ci-avant, mais couvre aussi des géométries et mécanismes généralement quelconques ; par exemple les éléments d'obturation 13 pourraient avoir leur axe de rotation fixé dans une direction généralement quelconque et pas seulement parallèle à l'axe de défilement du substrat. D'autres moyens, que les lamelles 15 ou les tiroirs 18-21 peuvent être utilisés, par exemple, des diaphragmes rotatifs ou à iris actionnés dans le plan de la paroi où ils sont prévus, etc.

## Revendications

1. Dispositif pour le revêtement de substrats au défilé se déplaçant suivant une direction de défilement, ce dispositif comprenant une enceinte de confinement (5) avec une ouverture d'entrée (7) et une ouverture de sortie (8) pour les substrats dans laquelle une source de vapeur du matériau de revêtement (4) est présente, cette enceinte (5) présentant une zone de traitement (6) communiquant avec la source de vapeur (4) à travers au moins une ouverture de traitement, cette source (4) étant telle à permettre de générer un flux de vapeur pour le revêtement d'un substrat, **caractérisé en ce que** des moyens de réglage sont prévus permettant de contrôler le flux de ladite vapeur à travers ladite ouverture de traitement (14) entre l'intérieur de l'enceinte de confinement (5) et un couloir tubulaire délimité par des parois résentant ladite ouverture et les moyens de réglage et s'étendant entre l'ouverture d'entrée (7) et l'ouverture de sortie (8), ce couloir comprenant la zone de traitement (6), les moyens de réglage comprenant des éléments d'obturation (13) pouvant être déplacés entre une position d'ouverture, dans laquelle le flux de ladite vapeur peut passer de l'enceinte de confinement (5) à travers l'ouverture de traitement vers le couloir et la zone de traitement (6), et une position de fermeture, dans laquelle la zone de traitement (6) est isolée par rapport à l'enceinte de confinement (5) et à la source de vapeur, l'enceinte de confinement étant telle à permettre une libre circulation et une répartition de la vapeur autour du couloir.

2. Dispositif suivant la revendication 1, dans lequel un espace libre est présent entre les parois de l'enceinte de confinement (5) et les parois du couloir permettant une circulation libre et une distribution de la vapeur dans l'enceinte de confinement (5) autour du couloir.

3. Dispositif suivant la revendication 1 ou 2, dans lequel le couloir s'étend suivant la direction de défilement entre une ouverture d'entrée (7) et une ouverture de sortie (8) de l'enceinte de confinement (5), ladite zone de traitement (6) étant située dans ce couloir et lesdits moyens de réglage étant tels à permettre de contrôler le flux de ladite vapeur entre ladite source de vapeur (4) et l'intérieur du couloir.

4. Dispositif suivant l'une quelconque des revendications précédentes, dans lequel le couloir présente des parois avec au moins une ouverture de traitement, ces parois étant constituées au moins partiellement desdits éléments d'obturation (13) qui peuvent être déplacés graduellement entre une position d'ouverture, dans laquelle le flux de ladite vapeur peut pénétrer à l'intérieur du couloir à partir de la source de vapeur (4) à travers l'ouverture de traitement, et une position de fermeture, dans laquelle l'intérieur du couloir est isolé par rapport à la source de vapeur (4).

5. Dispositif suivant l'une quelconque des revendications précédentes, dans lequel les éléments d'obturation (13) sont formés par des lamelles (15), chacune de ces lamelles (15) étant articulée par rapport à l'ouverture de traitement de manière à permettre de les basculer entre la position d'ouverture et la position de fermeture.

6. Dispositif suivant la revendication 4, dans lequel les lamelles (15) présentent une forme oblongue dont la direction longitudinale s'étend parallèlement à la direction de défilement des substrats (25) entre l'ouverture d'entrée (7) et l'ouverture de sortie (8) de l'enceinte de confinement (5).

7. Dispositif suivant l'une quelconque des revendications précédentes, dans lequel les éléments d'obturation (13) sont agencés d'une manière telle à pouvoir être déplacés suivant une direction parallèle à la direction de défilement entre la position d'ouverture et de fermeture.

8. Dispositif suivant l'une quelconque des revendications précédentes, dans lequel les éléments d'obturation (13) sont agencés d'une manière telle à pouvoir être déplacés transversalement par rapport à la direction de défilement entre la position d'ouverture et la position de fermeture.

9. Dispositif suivant l'une quelconque des revendications précédentes, dans lequel les éléments d'obturation (13) comprennent une succession de lamelles (15) parallèles qui, dans la position d'ouverture, s'étendent à une distance l'une de l'autre permettant au flux de passer entre ces lamelles (15) vers la zone de traitement (6) et qui, dans la position de fermeture, se touchant l'une à l'autre afin de fermer l'ouverture de traitement en isolant la source de vapeur (4) par rapport à la zone de traitement (6).

10. Dispositif suivant l'une quelconque des revendications précédentes, dans lequel les éléments d'obturation (13) peuvent être actionnés indépendamment l'un par rapport à l'autre de manière à permettre de régler la répartition du flux de vapeur vers la zone de traitement (6) en fonction de la section des substrats (25) à revêtir.

11. Dispositif suivant l'une quelconque des revendications précédentes, dans lequel le couloir susdit présente des parois maintenues à une température suffisamment élevée pour éviter une condensation de la vapeur du matériau de revêtement sur ces parois.

12. Dispositif suivant l'une quelconque des revendications précédentes, dans lequel l'enceinte de confinement (5) comprend des parois chauffées pour éviter que le matériau de revêtement se dépose sur ces parois.

13. Dispositif suivant l'une quelconque des revendications précédentes, dans lequel l'enceinte de confinement (5) et la zone de traitement (6) sont contenues dans une chambre à vide (3).

14. Dispositif suivant l'une quelconque des revendications précédentes, dans lequel des moyens sont prévues pour créer un plasma dans l'enceinte de confinement (5) d'une manière telle à évaporer le matériau de revêtement et pour polariser ce dernier en moyenne négativement par rapport à une contre électrode.

15. Dispositif suivant l'une quelconque des revendications précédentes, dans lequel la source de vapeur comprend un bac de rétention (4) contenant un métal, en particulier du zinc, à l'état liquide.

16. Dispositif suivant la revendication 15, dans lequel le bac de rétention (4) est alimenté en zinc liquide via un tube d'alimentation (9) plongé dans une réserve de zinc maintenue dans un four à vide (12) situé dans une chambre à vide (11).

17. Procédé pour le revêtement de substrats (25) au défilé se déplaçant suivant une direction de défilement à travers une zone de traitement (6), dans lequel de la vapeur d'un matériau de revêtement est générée dans une enceinte (5), cette vapeur passant à travers une ouverture de traitement vers la zone de traitement (6) où le matériau de revêtement se condense sur la surface des substrats (25), **caractérisé en ce que** la vapeur du matériau de revêtement présente dans l'enceinte de confinement (5) circule librement et est répartie autour d'un couloir, comprenant la zone de traitement, qui est délimité par des parois présentant ladite ouverture de traitement, le passage de la vapeur à travers l'ouverture de traitement vers l'intérieur de ce couloir étant contrôlé en réglant l'obturation de l'ouverture de traitement au moyen d'au moins un élément d'obturation (13) entre une position d'ouverture, dans laquelle ladite vapeur passe à travers l'ouverture de traitement vers le couloir avec la zone de traitement (6), et une position de fermeture, dans laquelle le passage de la vapeur vers le couloir à travers l'ouverture de traitement est empêché.

18. Procédé suivant la revendication 17, dans lequel l'on règle la répartition de la vapeur vers la zone de traitement (6) en fonction de la section des substrats (25) à revêtir.

19. Procédé suivant la revendication 17 ou 18, dans lequel l'élément d'obturation (13) est maintenu à une température suffisamment élevée pour éviter une condensation de la vapeur du matériau de revêtement sur cet élément (13).

20. Procédé suivant l'une quelconque des revendications 17 à 19, dans lequel les parois de l'enceinte de confinement (5) sont chauffées pour éviter que le matériau de revêtement se dépose sur ces parois.

21. Procédé suivant l'une quelconque des revendications 17 à 20, dans lequel l'enceinte de confinement (5) et la zone de traitement (6) sont maintenus sous vide, en particulier à une pression d'argon inférieure à 0,01 mbar.

22. Procédé suivant l'une quelconque des revendications 17 à 21, dans lequel le matériau de revêtement est évaporé au moyen d'un plasma réalisé dans l'enceinte de confinement (5) et dans lequel le matériau de revêtement dans la vapeur est polarisé en moyenne négativement par rapport à une contre-électrode.

23. Procédé suivant l'une quelconque des revendications 17 à 21, dans lequel la vapeur du matériau de revêtement est formée à partir d'un métal, en particulier du zinc, maintenu à l'état liquide dans l'enceinte de confinement (5), en particulier dans un bac de rétention formant une source à vapeur (4).

24. Procédé suivant la revendications 23, dans lequel le métal, en particulier du zinc, est introduit dans l'enceinte de confinement (5), en particulier dans un bac de rétention formant une source à vapeur (4), à partir d'une réserve de zinc maintenu dans un four à vide (12).

## Patentansprüche

1. Vorrichtung zur Durchlaufbeschichtung von Substraten, die sich entlang einer Durchlaufrichtung bewegen, wobei dieses Vorrichtung eine Einschlusskammer (5) mit einer Eintrittsöffnung (7) und einer Austrittsöffnung (8) für die Substrate umfasst, in der sich eine Dampfquelle für das Beschichtungsmaterial (4) befindet, wobei diese Kammer (5) eine Behandlungszone (6) aufweist, die über wenigstens eine Behandlungsöffnung mit der Dampfquelle (4) in Verbindung steht, wobei diese Quelle (4) derart beschaffen ist, dass sie die Erzeugung eines Dampfstromes für die Beschichtung eines Substrats gestattet, **dadurch gekennzeichnet, dass** Regelmittel vorgesehen sind, welche eine Kontrolle des Dampfstromes durch die Behandlungsöffnung (14) hindurch zwischen dem Inneren der Einschlusskammer (5) und einem röhrenförmigen Korridor gestatten, der von Wänden begrenzt wird, welche diese Öffnung und die Regelmittel aufweisen, und der sich zwischen der Eintrittsöffnung (7) und der Austrittsöffnung (8) erstreckt, wobei dieser Korridor die Behandlungszone (6) umfasst, wobei die Regelmittel Verschlusselemente (13) umfassen, die zwischen einer Öffnungsstellung, in welcher der Strom des Dampfes aus der Einschlusskammer (5) durch die Behandlungsöffnung hindurch zum Korridor und zur Behandlungszone (6) strömen kann, und einer Verschlussstellung, in welcher die Behandlungszone (6) in Bezug auf die Einschlusskammer (5) und die Dampfquelle isoliert ist, bewegt werden können, wobei die Einschlusskammer derart beschaffen ist, dass sie eine freie Zirkulation und eine Verteilung des Dampfes um den Korridor herum ermöglicht.

2. Vorrichtung nach Anspruch 1, wobei zwischen den Wänden der Einschlusskammer (5) und den Wänden des Korridors ein freier Raum vorhanden ist, der eine freie Zirkulation und eine Verteilung des Dampfes in der Einschlusskammer (5) um den Korridor herum ermöglicht.

3. Vorrichtung nach Anspruch 1 oder 2, wobei sich der Korridor entlang der Durchlaufrichtung zwischen einer Eintrittsöffnung (7) und einer Austrittsöffnung (8) der Einschlusskammer (5) erstreckt, wobei sich die Behandlungszone (6) in diesem Korridor befindet und die Regelmittel derart beschaffen sind, dass sie eine Kontrolle des Danpfstromes zwischen der Dampfquelle (4) und dem Inneren des Korridors gestatten.

4. Vorrichtung nach irgendeinem der vorhergehenden Ansprüche, wobei der Korridor Wände mit wenigstens einer Behandlungsöffnung aufweist, wobei diese Wände wenigstens teilweise aus den Verschlusselementen (13) bestehen, die schrittweise zwischen einer Öffnungsstellung, in welcher der Dampfstrom aus der Dampfquelle (4) durch die Behandlungsöffnung hindurch ins Innere des Korridors eindringen kann, und einer Verschlussstellung, in welcher das Innere des Korridors in Bezug auf die Dampfquelle (4) isoliert ist, bewegt werden können.

5. Vorrichtung nach irgendeinem der vorhergehenden Ansprüche, wobei die Verschlusselemente (13) von Lamellen (15) gebildet werden, wobei jede dieser Lamellen (15) in Bezug auf die Behandlungsöffnung gelenkig beweglich ist, um ein Schwenken derselben zwischen der Öffnungsstellung und der Verschlussstellung zu ermöglichen.

6. Vorrichtung nach Anspruch 4, wobei die Lamellen (15) eine längliche Form aufweisen, deren Längsrichtung sich parallel zur Durchlaufrichtung der Substrate (25) zwischen der Eintrittsöffnung (7) und der Austrittsöffnung (8) der Einschlusskammer (5) erstreckt.

7. Vorrichtung nach irgendeinem der vorhergehenden Ansprüche, wobei die Verschlusselemente (13) in einer solchen Weise vorgesehen sind, dass sie entlang einer Richtung parallel zur Durchlaufrichtung zwischen der Öffnungs- und der Verschlussstellung bewegt werden können.

8. Vorrichtung nach irgendeinem der vorhergehenden Ansprüche, wobei die Verschlusselemente (13) in einer solchen Weise vorgesehen sind, dass sie quer zur Durchlaufrichtung zwischen der Öffnungsstellung und der Verschlussstellung bewegt werden können.

9. Vorrichtung nach irgendeinem der vorhergehenden Ansprüche, wobei die Verschlusselemente (13) eine Folge paralleler Lamellen (15) umfassen, die sich in der Öffnungsstellung in einem Abstand voneinander erstrecken, was es dem Strom ermöglicht, zwischen diesen Lamellen (15) zur Behandlungszone (6) zu strömen, und die sich in der Verschlussstellung gegenseitig berühren, um die Behandlungsöffnung zu verschließen und zugleich die Dampfquelle (4) in Bezug auf die Behandlungszone (6) zu isolieren.

10. Vorrichtung nach irgendeinem der vorhergehenden Ansprüche, wobei die Verschlusselemente (13) unabhängig voneinander betätigt werden können, um die Verteilung des Dampfstromes zur Behandlungszone (6) hin in Abhängigkeit von dem Querschnitt der zu beschichtenden Substrate (25) regeln zu können.

11. Vorrichtung nach irgendeinem der vorhergehenden Ansprüche, wobei der oben genannte Korridor Wände aufweist, die auf einer ausreichend hohen Temperatur gehalten werden, um eine Kondensation des Dampfes des Beschichtungsmaterials auf diesen Wänden zu verhindern.

12. Vorrichtung nach irgendeinem der vorhergehenden Ansprüche, wobei die Einschlusskammer (5) beheizte Wände umfasst, um zu verhindern, dass sich das Beschichtungsmaterial auf diesen Wänden niederschlägt.

13. Vorrichtung nach irgendeinem der vorhergehenden Ansprüche, wobei die Einschlusskammer (5) und die Behandlungszone (6) in einer Vakuumkammer (3) enthalten sind.

14. Vorrichtung nach irgendeinem der vorhergehenden Ansprüche, wobei Mittel vorgesehen sind, um ein Plasma in der Einschlusskammer (5) in solcher Weise zu erzeugen, dass das Beschichtungsmaterial verdampft wird, und um dieses letztere in Bezug auf eine Gegenelektrode im Mittel negativ zu polarisieren.

15. Vorrichtung nach irgendeinem der vorhergehenden Ansprüche, wobei die Dampfquelle einen Speicherbehälter (4) umfasst, der ein Metall, insbesondere Zink, in flüssigem Zustand enthält.

16. Vorrichtung nach Anspruch 15, wobei der Speicherbehälter (4) über ein Zuleitungsrohr (9), das in einen Zinkvorrat eingetaucht ist, der in einem Vakuumofen (12) gehalten wird, welcher sich in einer Vakuumkammer (11) befindet, mit flüssigem Zink gespeist wird.

17. Verfahren zur Durchlaufbeschichtung von Substraten (25), die sich entlang einer Durchlaufrichtung durch eine Behandlungszone (6) bewegen, wobei in einer Kammer (5) Dampf eines Beschichtungsmaterials erzeugt wird, wobei dieser Dampf durch eine Behandlungsöffnung hindurch zur Behandlungszone (6) strömt, wo das Beschichtungsmaterial auf der Oberfläche der Substrate (25) kondensiert, **dadurch gekennzeichnet, dass** der in der Einschlusskammer (5) befindliche Dampf des Beschichtungsmaterials frei zirkuliert und um einen die Behandlungszone umfassenden Korridor, der von Wänden begrenzt wird, welche diese Behandlungsöffnung aufweisen, verteilt ist, wobei der Durchtritt des Dampfes durch die Behandlungsöffnung in das Innere dieses Korridors kontrolliert wird, indem der Verschluss der Behandlungsöffnung mittels wenigstens eines Verschlusselements (13) zwischen einer Öffnungsstellung, in welcher dieser Dampf durch die Behandlungsöffnung hindurch zum Korridor mit der Behandlungszone (6) strömt, und einer Verschlussstellung, in welcher der Durchtritt des Dampfes zum Korridor durch die Behandlungsöffnung hindurch verhindert wird, geregelt wird.

18. Verfahren nach Anspruch 17, wobei man die Verteilung des Dampfes hin zur Behandlungszone (6) in Abhängigkeit von dem Querschnitt der zu beschichtenden Substrate (25) regelt.

19. Verfahren nach Anspruch 17 oder 18, wobei das Verschlusselement (13) auf einer ausreichend hohen Temperatur gehalten wird, um eine Kondensation des Dampfes des Beschichtungsmaterials auf diesem Element (13) zu verhindern.

20. Verfahren nach irgendeinem der Ansprüche 17 bis 19, wobei die Wände der Einschlusskammer (5) beheizt werden, um zu verhindern, dass sich das Beschichtungsmaterial auf diesen Wänden niederschlägt.

21. Verfahren nach irgendeinem der Ansprüche 17 bis 20, wobei die Einschlusskammer (5) und die Behandlungszone (6) unter Vakuum gehalten werden, insbesondere bei einem Argondruck von weniger als 0,01 mbar.

22. Verfahren nach irgendeinem der Ansprüche 17 bis 21, wobei das Beschichtungsmaterial mittels eines in der Einschlusskammer (5) erzeugten Plasmas verdampft wird und wobei das Beschichtungsmaterial in dem Dampf in Bezug auf eine Gegenelektrode im Mittel negativ polarisiert wird.

23. Verfahren nach irgendeinem der Ansprüche 17 bis 21, wobei der Dampf des Beschichtungsmaterials aus einem Metall, insbesondere Zink, gebildet wird, das in der Einschlusskammer (5), insbesondere in einem Speicherbehälter, der eine Dampfquelle (4) bildet, in flüssigem Zustand gehalten wird.

24. Verfahren nach Anspruch 23, wobei das Metall, insbesondere Zink, aus einem Zinkvorrat, der in einem Vakuumofen (12) gehalten wird, in die Einschlusskammer (5), insbesondere in einen Speicherbehälter, der eine Dampfquelle (4) bildet, eingeleitet wird.

## Claims

1. Device for the coating of running substrates moving in a direction of travel, this device comprising a confinement enclosure (5) with an entry opening (7) and an exit opening (8) for the substartes in which a source of vapour of the coating material (4) is present, this enclosure (5) having a treatment zone (6) communicating with the vapour source (4) through at least one treatment opening, this source (4) being such as to make it possible to generate a vapour flow for coating a substrate, **characterised in that** regulation means are provided allowing to control the flow of said vapour through said treatment opening (14) between the inside of the confinement enclosure (5) and a tubular passage delimited by walls presenting said opening and the regulation means and extending between the entry opening (7) and the exit opening (8), this passage comprising the treatment zone (6), the regulation means comprising obturation elements (13) able to be moved between an open position in which the flow of said vapour can pass from the confinement enclosure (5) through the treatment opening towards the passage and the treatment zone (6) and a closed position in which the treatment zone (6) is isolated with respect to the confinement enclosure (5) and the vapour source, the confinement enclosure being such as to allow free circulation and distribution of the vapour around the passage.

2. Device according to claim 1, in which a free space is present between the walls of the confinement enclosure (5) and the walls of the passage allowing free circulation and a distribution of the vapour in the confinement enclosure (5) around the passage.

3. Device according to claim 1 or 2, in which the passage extends in the direction of travel between an entry opening (7) and an exit opening (8) of the confinement enclosure (5), said treatment zone (6) being situated in this passage and said regulation means being such as to make it possible to control the flow of said vapour between said vapour source (4) and the inside of the passage.

4. Device according to any one of the preceding claims, in which the passage has walls with at least one treatment opening, these walls consisting at least partially of said obturation elements (13) that can be moved gradually between an open position, in which the flow of said vapour can enter inside the passage from the vapour source (4) through the treatment opening, and a closed position in which the inside of the passage is isolated with respect to the vapour source (4).

5. Device according to any one of the preceding claims, in which the obturation elements (13) are formed by slats (15), each of these slats (15) being articulated with respect to the treatment opening so as to make it possible to tilt them between the open position and the closed position.

6. Device according to claim 4, in which the slats (15) have an oblong shape, the longitudinal direction of which extends parallel to the direction of travel of the substrates (25) between the entry opening (7) and the exit opening (8) of the confinement enclosure (5).

7. Device according to any one of the preceding claims, in which the obturation elements (13) are arranged so as to be able to be moved in a direction parallel to the direction parallel to the direction of travel between the open and closed position.

8. Device according to any one of the preceding claims, in which the obturation elements (13) are arranged so as to be able to be moved transversely with respect to the direction of travel between the open position and the closed position.

9. Device according to any one of the preceding claims, in which the obturation elements (13) comprise a succession of parallel slats (15) which, in the open position, extend at a distance from one another enabling the flow to pass between these slats (15) towards the treatment zone (6) and which, in the closed position, touch one another in order to close the treatment opening while isolating the vapour source (4) with respect to the treatment zone (6).

10. Device according to any one of the preceding claims, in which the obturation elements (13) can be actuated independently with respect to one another so as to make it possible to regulate the distribution of the vapour flow towards the treatment zone (6) according to the cross section of the substrates (25) to be coated.

11. Device according to any one of the preceding claims, in which the aforementioned passage has walls maintained at a sufficiently high temperature to prevent condensation of the vapour of the coating material on these walls.

12. Device according to any one of the preceding claims, in which the confinement enclosure (5) comprises heated walls in order to prevent the coating material being deposited on these walls.

13. Device according to any one of the preceding claims, in which the confinement enclosure (5) and the treatment zone (6) are contained in a vacuum chamber (3).

14. Device according to any one of the preceding claims, in which means are provided for creating a plasma in the confinement enclosure (5) so as to evaporate the coating material and to polarise the latter on average negatively with respect to a counter-electrode.

15. Device according to any one of the preceding claims, in which the vapour source comprises a retention vessel (4) containing a metal, in particular zinc, in the liquid state.

16. Device according to claim 15, in which the retention vessel (4) is supplied with liquid zinc via a supply tube (9) immersed in a zinc reserve maintained in a vacuum furnace (12) situated in a vacuum chamber (11).

17. Method for the coating of running substrates (25) moving in a direction of travel through a treatment zone (6), in which the vapour of a coating material is generated in an enclosure (5), this vapour passing through a treatment opening towards the treatment zone (6) where the coating material condenses on the surface of the substrates (25), **characterised in that** the vapour of the coating material present in the confinement enclosure (5) circulates freely and is distributed around a passage comprising the treatment zone being delimited by walls presenting said treatement opening, the passing of the vapour through the treatment opening towards the inside of this passage being controlled by regulating the obturation of the treatment opening by means of at least one obturation element (13) between an open position, in which said vapour passes through the treatment opening towards the passage with the treatment zone (6), and a closure position in which the passing of the vapour towards the passage through the treatment opening is prevented.

18. Method according to claim 17, in which the distribution of the vapour towards the treatment zone (6) is regulated according to the cross section of the substrates (25) to be coated.

19. Method according to claim 17 or 18, in which the obturation element (13) is maintained at a sufficiently high temperature to prevent condensation of the vapour of the coating material on this element (13).

20. Method according to any one of claims 17 to 19, in which the walls of the confinement enclosure (5) are heated in order to prevent the coating material being deposited on theses walls.

21. Method according to any one of claims 17 to 20, in which the confinement enclosure (5) and the treatment zone (6) are maintained under vacuum, in particular at an argon pressure of less than 0.01 mbar.

22. Method according to any one of claims 17 to 21, in which the coating material is evaporated by means of a plasma produced in the confinement enclosure (5) and in which the coating material in the vapour is polarised on average negatively with respect to a counter-electrode.

23. Method according to any one of claims 17 to 21, in which the vapour of the coating material is formed from a metal, in particular zinc, maintained in the liquid state in the confinement enclosure (5), in particular in a retention vessel forming a vapour source (4).

24. Method according to claim 23, in which the metal, in particular zinc, is introduced into the confinement enclosure (5), in particular in a retention vessel forming a vapour source (4), from a zinc reserve maintained in a vacuum furnace (12).
